# EUROPÄISCHE PATENTSCHRIFT

(11) **EP 3 420 370 B1**
(45) Veröffentlichungstag und Bekanntmachung des Hinweises auf die Patenterteilung: **10.11.2021**
(21) Anmeldenummer: 17732046.2
(22) Anmeldetag: 09.06.2017
(51) Int. Cl.: G01R 31/54, H01B 7/32

(54) **VERFAHREN ZUR ÜBERWACHUNG EINER LEITUNG UND MESSANORDNUNG MIT EINER LEITUNG**
METHOD FOR MONITORING A LINE, AND MEASURING ARRANGEMENT COMPRISING A LINE
PROCÉDÉ DE SURVEILLANCE D'UNE LIGNE ET ENSEMBLE DE MESURE COMPRENANT UNE LIGNE

(30) Priorität: 15.06.2016 DE 102016210601
(43) Veröffentlichungstag der Anmeldung: 02.01.2019
(73) Patentinhaber: LEONI Kabel GmbH, 91154 Roth (DE)
(72) Erfinder: KÖPPENDÖRFER, Erwin, 91126 Schwabach (DE); SCHILL, Markus, 80689 München (DE)
(74) Vertreter: FDST Patentanwälte
(86) Internationale Anmeldenummer: PCT/EP2017/064129
(87) Internationale Veröffentlichungsnummer: WO 2017/216061

(56) Entgegenhaltungen:
- EP-A1- 2 930 522
- WO-A1-2015/091552
- US-A1- 2015 077 131
- US-B1- 7 679 371

## Beschreibung

Die Erfindung betrifft ein Verfahren zur Überwachung einer Leitung, eine Messanordnung mit einer Leitung, sowie die Verwendung einer Leitung mit einem Messleiter.

Eine Leitung dient beispielsweise der Übertragung von Energie und/oder Signalen und weist hierzu zumindest eine Ader, üblicherweise mehrere Adern, d.h. isolierte Leiter auf. Mehrere Adern sind oftmals mittels eines gemeinsamen Leitungsmantels zu einer Leitung zusammengefasst. Bei vielen Anwendungen, beispielsweise im automotiven Bereich, unterliegen Leitungen diversen Belastungen, welche häufig bezüglich Dauer und Stärke unbekannt sind. Auch die potentiell vielfältigen und wechselreichen Umgebungsbedingungen, z.B. Wärmeeinflüsse, können oftmals gar nicht oder nicht hinreichend abgeschätzt werden, um den Verschleiß einer Leitung vorhersagen zu können. Um eine bestimmte Mindestlebensdauer garantieren zu können, wird eine Leitung daher typsicherweise überdimensioniert ausgelegt. Alternativ ist es möglich, eine Leitung hinsichtlich deren Dimensionierung und Materialwahl effizienter zu gestalten, indem im Betrieb oder zumindest in regelmäßigen Abständen eine Überwachung, d.h. Kontrolle der Leitung durchgeführt wird.

In der EP 2 930 522 A1 wird ein Verfahren zur ortsaufgelösten Diagnose eines Kabels beschrieben. Hierzu wird ein Impulspaar aus zwei zeitlich versetzten Impulsen eingespeist. Die Impulse interferieren an einer Stelle im Kabel und es entstehen dort lokal erhöhte elektrische Verluste. Die interferierten Impulse werden mit einer Auswerteeinheit erfasst und ausgewertet. Durch Variation des zeitlichen Abstands der Impulse wird eine ortsaufgelöste Abtastung entlang des Kabels realisiert.

In der WO 2015/091552 A1 wird eine Messanordnung zur Temperaturmessung beschrieben. Die Messanordnung weist zwei Signalleiter auf, welche von Materialien mit unterschiedlichen Dielektrizitätszahlen umgeben sind, sodass sich für ein parallel in beide Signalleiter eingespeistes Messsignal ein Laufzeitunterschied ergibt, welcher sich temperaturabhängig ändert.

Vor diesem Hintergrund ist es eine Aufgabe der Erfindung, ein Verfahren sowie eine Messanordnung anzugeben, mittels welchem bzw. welcher eine regelmäßige, vorzugsweise dauerhafte Überwachung einer Leitung auf besonders einfache und kostengünstige Weise realisiert ist. Die Überwachung soll dabei insbesondere in eingebauten Zustand der Leitung in einem Endprodukt und/oder im vorgesehenen Betrieb der Leitung erfolgen.

Die Aufgabe wird erfindungsgemäß gelöst durch ein Verfahren mit den Merkmalen gemäß Anspruch 1, durch eine Messanordnung mit den Merkmalen gemäß Anspruch 9 sowie durch eine Verwendung einer Leitung mit einem Messleiter gemäß Anspruch 12. Vorteilhafte Ausgestaltungen, Weiterbildungen und Varianten sind Gegenstand der Unteransprüche. Dabei gelten die Ausführungen im Zusammenhang mit dem Verfahren sinngemäß auch für die Messanordnung und die Verwendung sowie umgekehrt.

Das Verfahren dient zur Überwachung einer Leitung mit einer vorbestimmten Länge, d.h. die Leitung ist bereits auf eine bekannte Länge abgelängt und liegt nicht als Endlosware vor. Die Leitung weist einen Messleiter auf, welcher sich insbesondere entlang der Leitung erstreckt, vorzugsweise entlang der gesamten Leitung. Der Messleiter ist vorzugsweise als einfacher Draht oder Litzenleiter ausgebildet und besteht beispielsweise aus Kupfer.

Bei dem Verfahren werden mehrere Messpulse in den Messleiter eingespeist. Die mehreren Messpulse werden zeitlich nacheinander in einem zeitlichen Abstand eingespeist. Insbesondere wird ein erster Messpuls ausgesendet, d.h. in den Messleiter eingespeist, und zeitlich nach dem ersten Messpuls wird ein zweiter Messpuls ausgesendet, d.h. in den Messleiter eingespeist. Der zeitliche Abstand zweier aufeinanderfolgender Messpulse ist durch eine Taktrate bestimmt, mit welcher die Messpulse wiederkehrend erzeugt werden. In einem Normalzustand der Leitung weisen die Messpulse eine Laufzeit auf, welche durch die vorbestimmte Länge der Leitung vorbekannt ist. Die Laufzeit ergibt sich aus der Länge insbesondere in Kombination mit den Materialien, aus welchen die Leitung gefertigt ist. Dabei ist die Laufzeit bestimmt durch die Propagations- oder Ausbreitungsgeschwindigkeit eines Messpulses durch den Messleiter. Übliche Ausbreitungsgeschwindigkeiten liegen im Bereich von 1 bis 2,5 · 10^8 m/s und sind insbesondere von dem Material abhängig, welches zur Isolierung der Ader oder Adern verwendet wird.

Weiterhin werden bei dem Verfahren jeweils reflektierte Anteile der Messpulse erzeugt, welche in Gegenrichtung zu den Messpulsen propagieren. Dies erfolgt insbesondere durch entsprechende Ausgestaltung des Messleiters. Grundsätzlich ist zur Erzeugung einer Reflektion eine Impedanzänderung notwendig. Beispielsweise werden die reflektierten Anteile an einem offenen oder kurzgeschlossenen Ende des Messleiters erzeugt. Insbesondere wird also bei dem Verfahren ein reflektierter Anteil des ersten Messpulses erzeugt. Dieser reflektierte Anteil propagiert in Gegenrichtung durch den Messleiter, d.h. entgegen der ursprünglichen Richtung des ersten Messpulses.

Die Leitung wird dann überwacht, indem insbesondere fortlaufend oder wiederkehrend ermittelt wird, ob an einem vorgegebenen Messpunkt eine insbesondere zeitliche Überlagerung der Messpulse mit den reflektierten Anteilen vorliegt, d.h. insbesondere eine Überlagerung des reflektierten Anteils des ersten Messpulses mit dem zweiten Messpuls, und indem in Abhängigkeit der Überlagerung eine Abweichung der Laufzeit von der vorbekannten Laufzeit und eine Abweichung vom Normalzustand erkannt wird. Mit anderen Worten: anhand der Überlagerung der Messpulse mit den reflektierten Anteilen wird eine Veränderung der elektrischen Länge des Messleiters bestimmt, wobei die elektrische Länge der einfachen Laufzeit eines elektrischen Signals durch den Messleiter entspricht. Eine solche Veränderung ist ein Indikator dafür, dass sich auch der Zustand der Leitung insgesamt verändert hat. Eine solche Änderung des Zustands ist beispielsweise eine Erwärmung der Leitung über eine vorgegebene Betriebstemperatur hinaus oder ein Bruch oder sonstiger Verschleiß der Leitung. Durch Ermittlung der Überlagerung, wird demnach festgestellt, ob sich die Leitung im Normalzustand befindet oder ob die Leitung besonderen Umgebungseinflüssen ausgesetzt ist oder beschädigt ist.

Grundsätzlich ist es denkbar, eine Leitung z.B. mittels einer sogenannten Zeitbereichsreflektometrie, kurz TDR (time domain reflectometry) zu überwachen. Dabei wird in einen Leiter, welcher sich entlang der Leitung erstreckt ein Messpuls eingespeist und dessen Laufzeit durch den Leiter gemessen. Anhand der Laufzeit lassen sich dann Rückschlüsse auf den Zustand der Leitung ziehen. So weisen einige Isolationsmaterialien beispielsweise eine temperaturabhängige Dielektrizitätszahl auf, sodass eine Änderung der Temperatur der Leitung eine messbare Änderung der Laufzeit bewirkt. Die Messung und Auswertung mittels Zeitbereichsreflektometrie ist jedoch apparativ sehr aufwendig und zudem sehr kostenintensiv. Herkömmliche Systeme zur Zeitbereichsreflektometrie eignen sich somit nicht für Massenanwendungen und hohe Stückzahlen, d.h. sind besonders für den automotiven Bereich ungeeignet. Anwendung finden solche Systeme vielmehr üblicherweise im Laborbetrieb oder in Einzelanwendungen. Zwecks Gewicht- und Bauraumeinsparung ist es jedoch wünschenswert, auch in Endprodukten insbesondere mit hohen Stückzahlen eine regelmäßige oder sogar dauerhafte Überwachung einer Leitung auf möglichst platzsparende und kostengünstige Weise zu realisieren.

Der Erfindung liegt nunmehr die Überlegung zugrunde, die Überwachung der Leitung zu vereinfachen, indem auf eine aufwendige Zeitbereichsreflektometrie mit Laufzeitmessung verzichtet wird und stattdessen einfach eine Überlagerung von eingespeisten und reflektierten Messpulsen untersucht wird. Der reflektierte Anteil eines ersten Messpulses hat den Messleiter zweimal passiert, nämlich einmal auf dem Hinweg als Messpuls und ein zweites Mal auf dem Rückweg als reflektierter Anteil. Zeitlich nach dem ersten Messpuls wird ein zweiter Messpuls ausgesendet. Der reflektierte Anteil wird dann auf dem Rückweg zwangsläufig an einem bestimmten Punkt mit dem zweiten Messpuls überlagert. Die konkrete Position dieses bestimmten Punktes entlang der Leitung ist jedoch von der Ausbreitungsgeschwindigkeit der Messpulse abhängig und damit von den Umgebungsbedingungen und/oder dem Zustand der Leitung. Mit anderen Worten: der bestimmte Punkt wandert oder bewegt sich abhängig vom Zustand der Leitung entlang derselben, d.h. die Position des bestimmten Punktes ist veränderlich und verändert sich abhängig vom Zustand der Leitung. Der bestimmte Punkt wird auch als Überlagerungspunkt bezeichnet. Aufgrund der veränderlichen Position wird der bestimmte Punkt auch als wandernder Punkt bezeichnet.

Der zweite Messpuls und der reflektierte Anteil des ersten Messpulses weisen jeweils eine Spannung auf, nämlich eine Sendespannung bzw. eine Reflektionsspannung. Diese addieren sich am Punkt der Überlagerung, sodass sich eine Gesamtspannung ergibt, welche sich von der Spannung eines einzelnen Messpulses, d.h. der Sendespannung unterscheidet, nämlich um die Reflektionsspannung. Die Reflektionsspannung ist üblicherweise aufgrund von Dämpfungseffekten und einer unvollständigen Reflektion geringer als die ursprüngliche Sendespannung, beträgt jedoch typischerweise zumindest einige Millivolt und ist damit noch gut messbar. Ein entsprechender Spannungsunterschied ist besonders einfach ermittelbar, besonders im Vergleich mit einer Laufzeitmessung. So beträgt die Länge einer Leitung in einem Bordnetz eines Fahrzeugs üblicherweise lediglich wenige Meter bis maximal 10 oder 20 m. Die Laufzeit entlang solch einer Leitung liegt dann im Nano- oder sogar Pikosekundenbereich und ist nur schwierig messbar.

Der oben beschriebene Punkt der Überlagerung bewegt sich abhängig vom Zustand der Leitung entlang derselben. Am Messpunkt liegt folglich eine Überlagerung vor, wenn ebenjener Punkt mit dem Messpunkt zusammenfällt. Die Spannung am Messpunkt wird über die Sendespannung hinaus erhöht und eine Überlagerung erkannt, andernfalls wird lediglich die niedrigere Spannung des Messpulses gemessen und die Abwesenheit einer Überlagerung erkannt.

In einer geeigneten Ausgestaltung sind im Normalzustand der Leitung die Messpulse und die reflektierten Anteile am Messpunkt überlagert, sodass vorteilhaft eine Abweichung vom Normalzustand erkannt wird, falls keine Überlagerung vorliegt. Im Normalzustand ist der Messleiter also synchronisiert hinsichtlich der eingespeisten Messpulse und der reflektierten Anteile. Die Überwachung des Kabels ist in dieser Ausgestaltung auf eine besonders einfache qualitative Messung reduziert, bei welcher insbesondere lediglich geprüft wird, ob eine Überlagerung vorliegt oder nicht, d.h. ob die Messpulse und die reflektierten Anteil am Messpunkt synchron sind oder nicht. Liegt keine Überlagerung, d.h. keine Synchronisierung vor, wird somit erkannt, dass die Laufzeit der Messpulse von der vorbekannten Laufzeit abweicht und es wird entsprechend auf eine Zustandsänderung weg vom Normalzustand geschlossen.

Grundsätzlich ist auch eine umgekehrte Überwachung geeignet, bei welcher im Normalzustand keine Überlagerung vorliegt und dann eine Abweichung erkannt wird, wenn eine Überlagerung vorliegt. So lässt sich durch die Überlagerung ein bestimmter Grenzwert für die Abweichung markieren, dessen Erreichen mittels einer lediglich qualitativen Messung erkannt wird. Eine quantitative Messung ist vorteilhaft nicht notwendig.

Insgesamt wird also ein Zusammen- oder ein Auseinanderfallen des Messpunktes und des Überlagerungspunktes überwacht, um bei einer entsprechenden Änderung auf eine Zustandsänderung der Leitung zu schließen.

Die Überlagerung wird vorzugsweise gemessen, indem geprüft wird, ob am Messpunkt eine Überspannung bezüglich der Sendespannung, welche eine Ausgangsspannung ist, der Messpulse vorliegt. Die Überlagerung als Spannungsänderung über die Sendespannung hinaus ist auf diese Weise mit einfacher und kostengünstiger Elektronik ermittelbar. In einer geeigneten Ausgestaltung wird die Überlagerung mittels eines einfachen Komparators gemessen, welcher am Messpunkt die dort aktuell vorliegende Spannung mit der Sendespannung eines Messpulses vergleicht und auf diese Weise eine Überlagerung als Überspannung am Messpunkt erkennt.

Die Messpulse weisen jeweils eine zeitliche Breite auf, welche auch als Taktzeit bezeichnet wird. Zwischen zwei Pulsen liegt eine Pause mit einer Pausenzeit. Um eine möglichst definierte Überlagerung zu erzielen und diese möglichst eindeutig ermitteln zu können, sind die Messpulse zweckmäßigerweise deutlich kürzer als die Pausen, d.h. die Taktzeit ist deutlich kürzer als die Pausenzeit. Dabei wird unter "deutlich kürzer" insbesondere verstanden, dass die Taktzeit zumindest eine Größenordnung geringer ist als die Pausenzeit. Übliche Taktzeiten betragen zwischen 1 und 100 ns, übliche Pausenzeiten zwischen 0,1 und 100 µs.

Das Verfahren eignet sich besonders zur Realisierung mittels digitaler Schaltungstechnik. Dies ergibt sich insbesondere aus der Einfachheit der Messung. Heutige Mikroprozessoren für digitale Schaltungen sind regelmäßig zum Betrieb bei Taktraten im GHz-Bereich ausgebildet und eigenen sich daher auch vorliegend zur Erzeugung der Messpulse vor dem Hintergrund der benötigten Taktzeiten. Daher werden in einer besonders bevorzugten Ausgestaltung die Messpulse durch ein digitales Messsignal gebildet, d.h. als Bitfolge mit mehreren aufeinanderfolgenden Bits realisiert. Die Messpulse sind dann als eine Anzahl an An-Zuständen oder 1-Bits realisiert, z.B. bei einer Spannung von 5V, die Pausenzeiten als eine Folge von Aus-Zuständen oder 0-Bits, z.B. bei einer Spannung von 0V. Dass Messsignal ist dann eine Folge von Rechteckpulsen, nämlich den Messpulsen, welche jeweils durch Pausen beabstandet sind. Da die Bits der Bitfolge üblicherweise eine feste zeitliche Breite aufweisen und da die Messpulse wie oben beschrieben zweckmäßigerweise deutlich kürzer sind als die Pausen, wird ein Messpuls vorzugsweise durch lediglich ein oder wenige 1-Bits gebildet und eine Pause durch im Vergleich zur Anzahl der 1-Bits eines Messpulses mehrere 0-Bits realisiert. Auf diese Weise werden insbesondere die oben genannten Takt- und Pausenzeiten durch Bits fester Breite realisiert.

Vorzugsweise werden die Messpulse mit einer einstellbaren Taktrate wiederkehrend erzeugt, wobei die Taktrate angepasst wird, bis die Messpulse und die reflektierten Anteile bei einer angepassten Taktrate überlagert sind. Das Einstellen der Taktrate erfolgt hierbei nicht bei der Fertigung oder Konfektionierung der Leitung, sondern vielmehr in verbautem Zustand, insbesondere im Betrieb. Durch Einstellen der Taktrate wird vorteilhaft eine quantitative Messung der Abweichung vom Normalzustand realisiert. Durch Anpassung der Taktrate, d.h. effektiv durch eine Veränderung der Pausenzeiten, wird ein Laufzeitunterschied zwischen der tatsächlichen Laufzeit und der vorbekannten Laufzeit ausgeglichen. Die angepasste Taktrate wird dann zweckmäßigerweise mit der Taktrate im Normalzustand verglichen. Die Größe des Unterschieds stellt ein Maß für die Stärke der Abweichung dar und somit für die Stärke der Belastung oder Beschädigung des Kabels. Die Taktrate ist mit einem digitalen System besonders einfach einstellbar, indem die Pausenzeiten einfach durch Hinzufügen oder Entfernen von 0-Bits verlängert oder verkürzt werden.

Weiterhin lässt sich durch Einstellen der Taktrate eine quantitative Messung eines Betriebsparameters der Leitung realisieren. Ein solcher Betriebsparameter ist beispielsweise die Temperatur der Leitung. In einer geeigneten Ausgestaltung wird daher anhand der angepassten Taktrate ein Betriebsparameter, insbesondere eine Temperatur, der Leitung bestimmt. Die Verknüpfung der Taktrate mit dem Betriebsparameter ist beispielsweise über eine auf einem Speicher hinterlegte Tabelle realisiert. Alternativ wird der Betriebsparameter mittels eines vorbekannten funktionellen Zusammenhangs auf Grundlage der Taktrate berechnet.

Zusätzlich oder alternativ zu einer Temperaturmessung wird in einer geeigneten Variante die Leitung auf eine mechanische Belastung überprüft. Der Betriebsparameter ist hierbei die mechanische Belastung der Leitung, deren mechanische Integrität oder allgemein deren Funktionalität. Dem liegt die Überlegung zugrunde, dass eine mechanische Belastung, insbesondere eine Bruchstelle, im Messleiter zu einer verkürzten Laufzeit führt, mit entsprechenden Konsequenzen für die Überlagerung. Durch das eingangs beschriebene Messprinzip lässt sich demnach auch eine mechanische Beschädigung der Leitung erkennen. Dies ist besonders sinnvoll bei Leitungen, welche häufigen Biegewechselbelastungen ausgesetzt sind, beispielsweise im automotiven Bereich, insbesondere auch bei Robotern.

In einer zweckmäßigen Ausgestaltung ist entlang des Messleiters ein Material angeordnet, mit einer Dielektrizitätszahl, welche von einem Betriebsparamater, insbesondere der Temperatur, der Leitung abhängig ist. Dadurch ist auf besonders einfache Weise sichergestellt, dass wechselnde Umgebungsbedingungen einen messbaren Einfluss auf die Leitung haben. Der Messleiter ist dabei von dem Material zumindest teilweise umgeben oder liegt an diesem an, sodass die Ausbreitungsgeschwindigkeit von Messpulsen, welche durch den Messleiter propagieren, von dem Material beeinflusst wird. Vorzugsweise bildet das Material eine Isolierung einer Ader der Leitung und der Messleiter ist auf die Isolierung aufgebracht oder in diese eingebettet. Alternativ bildet das Material einen Leitungsmantel, mit welchem der Messleiter in Kontakt steht oder in welchen der Messleiter eingebettet ist.

In einer bevorzugten Ausgestaltung ist der Messleiter an einem Messanschluss einer Messeinheit angeschlossen, wobei mittels der Messeinheit die Messpulse erzeugt werden und die Überlagerung gemessen wird. Grundsätzlich ist auch eine von der Einspeisung getrennte Messung geeignet. Die Kombination und gemeinsame Durchführung mittels einer einzelnen Messeinheit ist jedoch besonders effizient. Der Messanschluss dient dann zugleich als Einspeisepunkt und als Messpunkt. Zweckmäßigerweise ist der Messanschluss ein serieller Anschluss einer digitalen Schaltung. Über den seriellen Anschluss wird dann einerseits ein digitales Messsignal in den Messleiter eingespeist und andererseits wird dort eine Überspannung gemessen.

Die Messanordnung weist eine Leitung auf, welche eine vorbestimmte Länge aufweist und welche einen Messleiter aufweist. Weiterhin weist die Messanordnung eine Messeinheit auf, wobei die Messeinheit zur Überwachung der Leitung derart ausgebildet ist, dass mehrere Messpulse in den Messleiter eingespeist werden, die Messpulse in einem Normalzustand der Leitung eine Laufzeit aufweisen, welche durch die vorbestimmte Länge der Leitung vorbekannt ist, jeweils reflektierte Anteile der Messpulse erzeugt werden, welche in Gegenrichtung zu den Messpulsen propagieren, die Leitung überwacht wird, indem ermittelt wird, ob an einem vorgegebenen Messpunkt eine Überlagerung der Messpulse mit den reflektierten Anteilen vorliegt, und indem in Abhängigkeit der Überlagerung eine Abweichung der Laufzeit von der vorbekannten Laufzeit und eine Abweichung vom Normalzustand erkannt wird. Die Messanordnung ist insbesondere zur Durchführung des oben beschriebenen Verfahrens ausgebildet. Die Vorteile ergeben sich entsprechend.

In einer zweckmäßigen Weiterbildung werden die Messpulse mit einer Taktrate erzeugt und die Taktrate ist in Abhängigkeit der vorbekannten Laufzeit im Normalzustand und in Abhängigkeit der vorbestimmten Länge der Leitung eingestellt. Dadurch ist sichergestellt, dass im Normalzustand eine Überlagerung der Messpulse und der reflektierten Anteile vorliegt und eine Abweichung vom Normalzustand durch ein Verschwinden der Überlagerung auf einfache Weise erkennbar ist. Hierbei wird die Taktrate demnach herstellerseitig, d.h. bei der Konfektionierung oder Fertigung der Leitung eingestellt, und zwar auf eine Normaltaktrate. Dazu wird beispielsweise die Messeinheit derart konfiguriert, dass diese entsprechend lange Pausen zwischen den Messpulsen erzeugt. Die auf diese Weise vorbereitete Messanordnung wird dann einfach im Endprodukt, z.B. einem Fahrzeug, verbaut.

Die Leitung weist üblicherweise zumindest eine Ader auf, alternativ mehrere Adern, Leiter und/oder sonstige funktionelle Elemente, z.B. optische Fasern oder eine Zugentlastung. In mechanischer Hinsicht weist die Leitung zudem eine neutrale Faser auf, welche bei einer Biegebelastung keine Längenänderung erfährt. Diese neutrale Faser ist nicht notwendigerweise ein konkreter Bestandteil der Leitung, sondern vielmehr allgemein diejenige Linie in Längsrichtung, welche beim Biegen keine Längenänderung erfährt. Bezüglich der neutralen Faser ist der Messleiter in radialer Richtung, d.h. senkrecht zur Längsrichtung, vorzugsweise weiter außen angeordnet als die Ader. Dadurch ist gewährleistet, dass der Messleiter insbesondere beim Biegen der Leitung einer stärkeren mechanischen Belastung ausgesetzt ist als die Ader und daher auch früher verschleißt und bricht. Ein potentielles Versagen der Ader wird dann frühzeitig durch die vorherige Beschädigung des Messleiters erkannt. Zweckmäßigerweise wird zunächst ein Bruch des Messleiters erkannt und daraufhin ein Warnsignal ausgegeben, sodass die Leitung entfernt werden kann, bevor auch die Ader ausfällt. Dadurch ist es auch möglich, die Ader deutlich geringer zu dimensionieren, da mit dem Messleiter eine zuverlässige Überwachung realisiert ist, welche eine übermäßige Auslegung der Ader auf Extremfälle unnötig macht. Als Folge hiervon werden vorteilhaft Kosten und Bauraum eingespart.

Das Verfahren und die Messanordnung eignen sich besonders zur Verwendung in einem Bordnetz eines Fahrzeugs. Bei einem solchen Bordnetz sind die Längen der Leitungen im Voraus bekannt, sodass auch die Laufzeiten im Normalzustand bekannt sind und die Messpulse, genauer deren Taktrate, bereits im Voraus eingestellt werden kann. Dadurch ist es möglich, das oben genannte Verfahren zur Überwachung anzuwenden.

Dabei sind zumindest zwei Varianten geeignet. In einer ersten Variante wird eine Leitung mit entsprechendem Messleiter im Bordnetz verbaut und eine geeignete Messeinheit, an welche der Messleiter angeschlossen wird, ist bereits in das Bordnetz oder in das Fahrzeug integriert, z.B. als Bestandteil einer Steuereinrichtung. In einer zweiten Variante ist die Messeinheit als eigenständige Einheit in die Leitung integriert, sodass diese eine intelligente Leitung ist, welche sich selbstständig überwacht. Die Messeinheit wird hierbei sinnvollerweise mit einer übergeordneten Steuereinheit des Bordnetzes oder des Fahrzeugs verbunden. Geeignet ist aber auch eine eigenständige, insbesondere autonome Ausgestaltung der Leitung. Dabei weist die Leitung beispielsweise noch eine Sicherung auf, welche von der Messeinheit angesteuert wird und beispielsweise eine Ader der Leitung vom Bordnetz trennt, falls eine Abweichung vom Normalzustand erkannt wird.

Nachfolgend werden Ausführungsbeispiele der Erfindung anhand einer Zeichnung näher erläutert. Darin zeigen jeweils schematisch:
Fig. 1 eine Messanordnung,
Fig. 2 ein Messsignal,
Fig. 3 einen Messpuls und einen reflektierten Anteil desselben, und
Fig. 4 eine Überlagerung eines Messpulses und eines reflektierten Anteil.

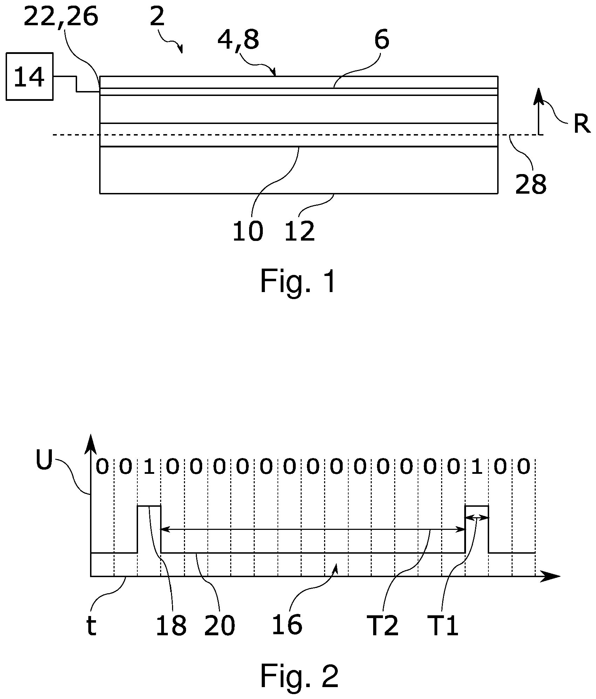

In Fig. 1 ist eine Messanordnung 2 dargestellt. Diese weist eine Leitung 4 auf, welche wiederum einen Messleiter 6 aufweist, welcher sich in Längsrichtung entlang der Leitung 4 erstreckt. Die Leitung 4 ist im gezeigten Ausführungsbeispiel eine einfache einadrige Leitung 4, d.h. eine Ader 8 mit einem zentralen Leiter 10, welcher von einer Isolierung 12 umgeben ist. In diese Isolierung 12 ist der Messleiter 6 eingebettet. In einer nicht gezeigten Variante weist die Leitung 4 mehrere, unter Umständen unterschiedliche Adern 8 auf und/oder andere Leitungs- oder Funktionselemente.

Der Messleiter 6 ist an eine Messeinheit 14 angeschlossen, sodass die Leitung 4 hinsichtlich einer Abweichung von einem Normalzustand überwacht werden kann. Beispiele für eine solche Abweichung sind eine übermäßige Erwärmung der Leitung 4 über eine vorgegebene Betriebstemperatur hinaus und ein Bruch infolge eines übermäßigen Verbiegens der Leitung 4. Die Überwachung der Leitung 4 wird nachfolgend im Detail anhand der Fig. 2 bis 4 näher erläutert.

Die Messeinheit 14 erzeugt ein Messsignal 16, welches aus periodisch wiederkehrenden Messpulsen 18 mit dazwischen eingefügten Pausen 20 besteht. Ein solches Messsignal 16 ist ausschnittweise in Fig. 2 als eine Spannung U gegen die Zeit t aufgetragen. Das gezeigte Messsignal 16 ist hier ein digitales Messsignal 16, bei welchem die Messpulse 18 und die Pausen 20 als Bitfolge realisiert sind. Ein jeweiliger Messpuls 18 entspricht hierbei einem einzelnen 1-Bit, eine Pause 20 ist aus mehreren 0-Bits zusammengesetzt. Die einzelnen Bits sind durch vertikale, gestrichene Linien angedeutet. Die Messpulse 18 sind deutlich kürzer als die Pausen 20, insbesondere wenigsten um eine Größenordnung kürzer. Insgesamt ergibt sich ein wiederkehrendes Rechtecksignal.

Ein jeweiliger Messpuls 18 weist eine Taktzeit T1 auf, welche typischerweise im Bereich zwischen 1 und 10 ns liegt. Eine jeweilige Pause 20 dauert eine Pausenzeit T2 lang an, welche typischerweise zwischen 0,1 und 100 µs beträgt. Daraus ergibt sich eine Taktrate, d.h. eine Wiederholrate der Messpulse 18, im Bereich von mehreren 10 KHz bis zu mehreren 100 MHz oder sogar wenigen Gigahertz. Eine solche Bitfolge lässt sich besonders einfach mittels einer digitalen Schaltung realisieren, sodass die Messeinheit 14, welche dann eine solche Schaltung umfasst, besonders einfach und kompakt ist.

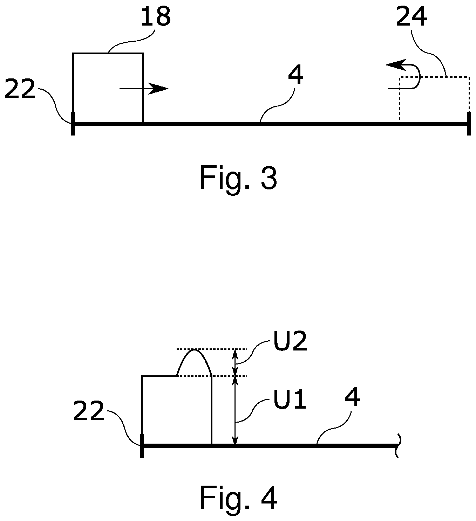

Die Messpulse 18 werden zur Überwachung der Leitung 4 in den Messleiter 6 eingespeist, und zwar an einem Messanschluss 22, an welchem die Messeinheit 14 an den Messleiter 6 angeschlossen ist und welcher somit zugleich ein Einspeisepunkt ist. Am Messanschluss 22 weist ein jeweiliger Messpuls 18 eine Spannung U auf, welche als Sendespannung U1 bezeichnet wird. Der Messpuls 18 propagiert entlang des Messleiters 6 und wird dabei üblicherweise abgeschwächt, d.h. bedämpft. Endseitig wird ein Teil des Messpulses 18 als reflektierter Anteil 24 reflektiert und propagiert in Gegenrichtung, d.h. zurück in Richtung des Messanschluss 22. Dies ist in Fig. 3 dargestellt, welche die Leitung 4 schematisch zeigt sowie am linken Ende, d.h. am Messanschluss 22 einen Messpuls 18 und am rechten Ende den reflektierten Anteil 24 des Messpulses 18.

Da fortlaufend Messpulse 18 eingespeist werden trifft der rücklaufende reflektierte Anteil 24 zwangsläufig auf einen später eingespeisten Messpuls 18 und überlagert sich mit diesem. Dies ist schematisch in Fig. 4 dargestellt, welche ausschnittsweise die Leitung 4 zeigt sowie eine Überlagerung des reflektierten Anteils 24 eines ersten Messpulses 18 mit einem zweiten Messpuls 18, welcher zeitlich nach dem ersten Messpuls 18 eingespeist wurde. Die Überlagerung führt zu einer Spannung U, welche größer ist als die ursprüngliche Sendespannung U1. Der Unterschied ist gerade eine Reflektionsspannung U2, d.h. die Spannung des reflektierten Anteils 24. Insgesamt liegt somit eine Überspannung vor.

Das Vorliegen dieser Überspannung wird nunmehr geprüft, um die Leitung 4 zu überwachen. Dazu wird an einem vorgegebenen, d.h. festgelegten Messpunkt 26 die Spannung im Messleiter 6 gemessen. Bevorzugterweise ist der Messpunkt 26 wie im Ausführungsbeispiel gleich dem Messanschluss 22. Denkbar ist jedoch auch eine andere Position entlang des Messleiters 6. Am Messpunkt 26 wird ermittelt, ob eine Überlagerung vorliegt, indem beispielsweise auf eine Überspannung geprüft wird. Eine aufwendige Laufzeitmessung entfällt.

Vorliegend ist die Taktrate derart eingestellt, dass im Normalzustand am Messpunkt 26 eine Überlagerung vorliegt. Werden die Umgebungsbedingungen verändert oder wird die Leitung 4 beschädigt, so ändert sich der Zustand der Leitung 4. Beispielsweise wird die Leitung 4 erwärmt und die Isolierung 10 weist eine temperaturabhängige Dielektrizitätszahl auf, sodass die Erwärmung zu einer veränderten Laufzeit der Messpulse 18 im Messleiter 6 führt. Dadurch geht aber auch die vorab eingestellt Überlagerung verloren, d.h. die anfänglich eingestellte Synchronisation zwischen eingespeisten Messpulsen 18 und reflektierten Anteilen 24 am Messpunkt 26 geht verloren. Es wird keine Überspannung mehr erzeugt. Dies wird von der Messeinheit 14 erkannt und daraus auf eine Abweichung vom Normalzustand geschlossen.

Alternativ oder zusätzlich zur Erwärmung ist auch ein mechanischer Verschleiß der Leitung 4 erkennbar. Bei einer Biegebewegung wird zwangsläufig auch der Messleiter 6 einer entsprechend mechanischen Belastung ausgesetzt. Bei Verschleiß des Messleiters 6 entsteht dann eine Störstelle oder sogar eine Bruchstelle, welche effektiv zu einem verkürzten Messleiter 6 führt, sodass auch hierbei die anfängliche Überlagerung verloren geht und im Ergebnis die Messeinheit 14 den Verschleiß erkennt.

Um sicherzustellen, dass der Messleiter 6 vor dem Leiter 10 der Ader 8 bricht, ist der Messleiter 6 bezüglich einer neutralen Faser 28 der Leitung 4 in radialer Richtung R weiter außen angeordnet als die Ader 8. Dadurch unterliegt der Messleiter 6 einer stärkeren mechanischen Belastung und verschleißt entsprechend schneller.

Das Ermitteln, ob eine Überlagerung vorliegt oder nicht ist bereits ausreichend, um eine Überwachung der Leitung 4 zu realisieren. In einer Variante wird jedoch zusätzlich zu oder anstelle einer solchen lediglich qualitativen Überwachung eine quantitative Überwachung durchgeführt, welche auch eine Bestimmung eines Betriebsparameters, z.B. der Temperatur der Leitung 4 ermöglicht. Dazu wird mittels der Messeinheit 14 die Taktrate angepasst und dabei solange verändert, bis eine Überlagerung vorliegt. Bei einer Veränderung der Laufzeit wird also die Taktrate angepasst, um wieder eine Überlagerung herzustellen, d.h. die Messpulse und die reflektierten Anteile werden synchronisiert. Die angepasste Taktrate ist dann ein Maß für die Stärke der Änderung des Zustands der Leitung 4. Beispielsweise ist durch regelmäßige oder kontinuierliche Anpassung der Taktrate eine quantitative Temperaturmessung realisiert. Die Taktrate wird beispielsweise angepasst, indem die Pausen 20 verlängert oder verkürzt werden, d.h. indem 0-Bits hinzugefügt oder entfernt werden.

## Patentansprüche

1. Verfahren zur Überwachung einer Leitung (4) mit einer vorbestimmten Länge und mit einem Messleiter (6), wobei
- mehrere Messpulse (18) in den Messleiter (6) eingespeist werden,
- die Messpulse (18) in einem Normalzustand der Leitung eine Laufzeit aufweisen, welche durch die vorbestimmte Länge der Leitung vorbekannt ist,
- jeweils reflektierte Anteile (24) der Messpulse erzeugt werden, welche in Gegenrichtung zu den Messpulsen propagieren,
**dadurch gekennzeichnet,**
- **dass** die Leitung überwacht wird, indem ermittelt wird, ob an einem vorgegebenen Messpunkt eine Überlagerung (U1,U2) der Messpulse mit den reflektierten Anteilen vorliegt, und indem in Abhängigkeit der Überlagerung eine Abweichung der Laufzeit von der vorbekannten Laufzeit und eine Abweichung vom Normalzustand erkannt wird.

2. Verfahren nach dem vorhergehenden Anspruch, wobei im Normalzustand der Leitung die Messpulse und die reflektierten Anteile am Messpunkt überlagert sind.

3. Verfahren nach einem der vorhergehenden Ansprüche, wobei die Überlagerung gemessen wird, indem geprüft wird, ob am Messpunkt eine Überspannung bezüglich einer Sendespannung der Messpulse vorliegt.

4. Verfahren nach einem der vorhergehenden Ansprüche, wobei die Messpulse durch ein digitales Messsignal gebildet werden.

5. Verfahren nach einem der vorhergehenden Ansprüche, wobei die Messpulse mit einer einstellbaren Taktrate wiederkehrend erzeugt werden, welche angepasst wird, bis die Messpulse und die reflektierten Anteile bei einer angepassten Taktrate überlagert sind.

6. Verfahren nach dem vorhergehenden Anspruch, wobei anhand der angepassten Taktrate ein Betriebsparameter, insbesondere eine Temperatur, der Leitung bestimmt wird.

7. Verfahren nach einem der vorhergehenden Ansprüche, wobei entlang des Messleiters ein Material angeordnet ist, mit einer Dielektrizitätszahl, welche von einem Betriebsparamater der Leitung abhängig ist.

8. Verfahren nach einem der vorhergehenden Ansprüche, wobei der Messleiter an einem Messanschluss einer Messeinheit angeschlossen ist, mittels welcher die Messpulse erzeugt werden und mittels welcher die Überlagerung gemessen wird.

9. Messanordnung (2) mit einer Leitung (4), welche eine vorbestimmte Länge aufweist und welche einen Messleiter (6) aufweist, und mit einer Messeinheit (14) wobei die Messeinheit zur Überwachung der Leitung derart ausgebildet ist, dass
― mehrere Messpulse (18) in den Messleiter eingespeist werden,
― die Messpulse in einem Normalzustand der Leitung eine Laufzeit aufweisen, welche durch die vorbestimmte Länge der Leitung vorbekannt ist,
― jeweils reflektierte Anteile (24) der Messpulse erzeugt werden, welche in Gegenrichtung zu den Messpulsen propagieren,
**dadurch gekennzeichnet,**
― **dass** die Leitung überwacht wird, indem ermittelt wird, ob an einem vorgegebenen Messpunkt eine Überlagerung (U1,U2) der Messpulse mit den reflektierten Anteilen vorliegt, und indem in Abhängigkeit der Überlagerung eine Abweichung der Laufzeit von der vorbekannten Laufzeit und eine Abweichung vom Normalzustand erkannt wird.

10. Messanordnung nach dem vorhergehenden Anspruch, wobei die Messeinheit derart ausgebildet ist, dass die Messpulse mit einer Taktrate erzeugt werden, und wobei die Taktrate in Abhängigkeit der vorbekannten Laufzeit im Normalzustand und in Abhängigkeit der vorbestimmten Länge der Leitung eingestellt ist.

11. Messanordnung nach einem der beiden vorhergehenden Ansprüche, wobei die Leitung zumindest eine Ader aufweist sowie eine neutrale Faser, welche bei einer Biegebelastung keine Längenänderung erfährt und bezüglich welcher der Messleiter in radialer Richtung weiter außen angeordnet ist als die Ader.

12. Verwendung einer Leitung mit einem Messleiter in einem Bordnetz mit einer Messeinheit, zur Durchführung eines Verfahrens nach einem der Ansprüche 1 bis 8.

## Claims

1. Method for monitoring a line (4) with a predetermined length and with a measuring conductor (6), wherein
― a plurality of measuring pulses (18) are fed into the measuring conductor,
― the measuring pulses, in a normal state of the line, have a transit time, which is previously known due to the predetermined length of the line,
― reflected portions (24) of the measuring pulses are respectively generated, which propagate in the opposite direction to the measuring pulses,
**characterized in**
― **that** the line is monitored by determining whether there is an overlay (U1, U2) of the measuring pulses with the reflected portions at a predetermined measuring point, and by recognizing, in dependance on the overlay, a deviation of the transit time from the previously known transit time and a deviation from the normal state.

2. Method according to the preceding claim, wherein in the normal state of the line the measuring pulses and the reflected portions are overlaid at the measuring point.

3. Method according to one of the preceding claims, wherein the overlay is measured by checking whether there is an overvoltage at the measuring point with respect to a transmission voltage of the measuring pulses.

4. Method according to one of the preceding claims, wherein the measuring pulses are formed by a digital measuring signal.

5. Method according to one of the preceding claims, wherein the measuring pulses are recurrently generated at a settable clock rate, which is adjusted until the measuring pulses and the reflected portions are overlaid at an adjusted clock rate.

6. Method according to the preceding claim, wherein an operating parameter, in particular a temperature, of the line is determined based on the adjusted clock rate.

7. Method according to one of the preceding claims, wherein a material is arranged along the measuring conductor, with a dielectric constant that depends on an operating parameter of the line.

8. Method according to one of the preceding claims, wherein the measuring conductor is connected to a measuring terminal of a measuring unit, by means of which the measuring pulses are generated and by means of which the overlay is measured.

9. Measuring arrangement (2) with a line (4) having a predetermined length and having a measuring conductor (6), and with a measuring unit (14), wherein the measuring unit is designed to monitor the line in such a way that
― a plurality of measuring pulses (18) are fed into the measuring conductor,
― the measuring pulses, in a normal state of the line, have a transit time, which is previously known due the predetermined length of the line,
― reflected portions (24) of the measuring pulses are respectively generated, which propagate in the opposite direction to the measuring pulses,
**characterized in**
― **that** the line is monitored by determining whether there is an overlay (U1, U2) of the measuring pulses with the reflected portions at a predetermined measuring point, and by recognizing, in dependance on the overlay, a deviation of the transit time from the previously known transit time and a deviation from the normal state.

10. Measuring arrangement according to the preceding claim, wherein the measuring unit is designed in such a way that the measuring pulses are generated at a clock rate, and wherein the clock rate is set as a function of the previously known transit time in the normal state and as a function of the predetermined length of the line.

11. Measuring arrangement according to one of the two preceding claims, wherein the line has at least one core as well as a neutral fibre, which does not undergo any change in length when subjected to a bending load and with respect to which the measuring conductor is arranged further out in the radial direction than the core.

12. Use of a line with a measuring conductor in an on-board electrical system with a measuring unit, for carrying out a method according to one of claims 1 to 8.

## Revendications

1. Procédé de surveillance d'une ligne (4) d'une longueur prédéterminée avec un conducteur de mesure (6), dans lequel
― une pluralité d'impulsions de mesure (18) sont introduites dans le conducteur de mesure,
― les impulsions de mesure, dans un état normal de la ligne, ont un temps de transit, qui est connu à l'avance en raison de la longueur prédéterminée de la ligne,
― des parties réfléchies (24) des impulsions de mesure sont respectivement générées, qui se propagent dans la direction opposée aux impulsions de mesure,
**caractérisé en ce**
― **que** la ligne est surveillée en déterminant s'il existe une superposition (U1, U2) des impulsions de mesure avec les parties réfléchies à un point de mesure prédéterminé, et en reconnaissant, en fonction de la superposition, un écart du temps de transit par rapport au temps de transit connu à l'avance et un écart par rapport à l'état normal.

2. Procédé selon la revendication précédente, dans lequel, dans l'état normal de la ligne, les impulsions de mesure et les parties réfléchies sont superposées au point de mesure.

3. Procédé selon l'une des revendications précédentes, dans lequel la superposition est mesurée en vérifiant s'il existe une surtension au point de mesure par rapport à une tension de transmission des impulsions de mesure.

4. Procédé selon l'une des revendications précédentes, dans lequel les impulsions de mesure sont formées par un signal de mesure numérique.

5. Procédé selon l'une des revendications précédentes, dans lequel les impulsions de mesure sont générées de manière récurrente à une fréquence d'horloge réglable, qui est ajustée jusqu'à ce que les impulsions de mesure et les parties réfléchies sont superposées à une fréquence d'horloge ajustée.

6. Procédé selon la revendication précédente, dans lequel un paramètre de fonctionnement, en particulier une température, de la ligne est déterminé sur la base de la fréquence d'horloge ajustée.

7. Procédé selon l'une des revendications précédentes, dans lequel un matériau est disposé le long du conducteur de mesure, avec une constante diélectrique, qui dépend d'un paramètre de fonctionnement du conducteur.

8. Procédé selon l'une des revendications précédentes, dans lequel le conducteur de mesure est relié à une connexion de mesure d'une unité de mesure au moyen de laquelle les impulsions de mesure sont générées et au moyen de laquelle la superposition est mesurée.

9. Dispositif de mesure (2) avec une ligne (4) d'une longueur prédéterminée, qui comprend un conducteur de mesure (6), et avec une unité de mesure (14), dans lequel l'unité de mesure est conçue pour surveiller la ligne de telle manière que
― une pluralité d'impulsions de mesure (18) sont introduites dans le conducteur de mesure,
― les impulsions de mesure, dans un état normal de la ligne, ont un temps de transit, qui est connu à l'avance en raison de la longueur prédéterminée de la ligne,
― des parties réfléchies (24) des impulsions de mesure sont respectivement générées, qui se propagent dans la direction opposée aux impulsions de mesure,
**caractérisé en ce**
― **que** la ligne est surveillée en déterminant s'il existe une superposition (U1, U2) des impulsions de mesure avec les composantes réfléchies à un point de mesure prédéterminé, et en reconnaissant, en fonction de la superposition, un écart du temps de transit par rapport au temps de transit connu à l'avance et un écart par rapport à l'état normal.

10. Dispositif de mesure selon la revendication précédente, dans lequel l'unité de mesure est conçue de telle sorte que les impulsions de mesure sont générées à une fréquence d'horloge, et dans lequel la fréquence d'horloge est réglée en fonction du temps de transit connu à l'avance dans l'état normal et en fonction de la longueur prédéterminée de la ligne.

11. Dispositif de mesure selon l'une des deux revendications précédentes, dans lequel la ligne comprend au moins une âme ainsi qu'une fibre neutre, qui ne subit aucune modification de longueur lorsqu'elle est soumise à une charge de flexion et par rapport à laquelle le conducteur de mesure est disposé plus loin dans la direction radiale que l'âme.

12. Utilisation d'une ligne avec un conducteur de mesure dans un réseau de bord avec une unité de mesure, pour la mise en oeuvre d'un procédé selon l'une des revendications 1 à 8.
